Europäisches Patentamt

European Patent Office

Office européen des brevets

(19)

(11) **EP 0 454 859 B1**

(12) **EUROPEAN PATENT SPECIFICATION**

(45) Date of publication and mention
of the grant of the patent:
**14.01.1998 Bulletin 1998/03**

(21) Application number: **90916371.9**

(22) Date of filing: **07.11.1990**

(51) Int Cl.$^6$: **H01L 27/02**, G05F 1/46

(86) International application number:
**PCT/JP90/01444**

(87) International publication number:
**WO 91/06980 (16.05.1991 Gazette 1991/11)**

(54) **SEMICONDUCTEUR INTEGRATED CIRCUIT**

INTEGRIERTE HALBLEITERSCHALTUNG

CIRCUIT INTEGRE A SEMI-CONDUCTEURS

(84) Designated Contracting States:
**DE FR GB**

(30) Priority: **07.11.1989 JP 289118/89**

(43) Date of publication of application:
**06.11.1991 Bulletin 1991/45**

(73) Proprietors:
• **FUJITSU LIMITED**
**Kawasaki-shi, Kanagawa 211 (JP)**
• **FUJITSU VLSI LIMITED**
**Kasugai-shi Aichi 487 (JP)**

(72) Inventors:
• **NAKANO, Tomio 5-37-3, Wakinoshima-cho**
**Gifu 507 (JP)**
• **KATO, Yoshiharu Yamayoshihausu 202**
**Kasugai-shi Aichi 486 (JP)**

• **NOMURA, Hidenori 117-401, 9-2, Takamoridai**
**Aichi 487 (JP)**

(74) Representative: **Rackham, Stephen Neil et al**
**GILL JENNINGS & EVERY,**
**Broadgate House,**
**7 Eldon Street**
**London EC2M 7LH (GB)**

(56) References cited:
JP-A- 5 423 340          JP-A-55 156 354
JP-A-59 110 209          JP-A-59 112 640

• **IEEE JOURNAL OF SOLID-STATE CIRCUITS.**
**vol. 22, no. 3, June 1987, NEW YORK US**
• **pages 437 - 441 T. FURUYAMA ET AL. 'A New**
**On-chip Voltage Converter for Submicrometer**
**High-Density DRAM's'**
• **PATENT ABSTRACTS OF JAPAN vol. 012, no.**
**043 (P-664)9 February 1988**

## Description

### TECHNICAL FIELD

The present invention relates to a semiconductor integrated circuit, and more particularly, relates to a semiconductor integrated circuit for dropping an external power source voltage to thereby obtain an internal power source voltage.

### BACKGROUND ART

In general, preferably the miniaturizing a semiconductor elements is continued because the integration level of semiconductor integrated circuits can be thus enhanced. Nevertheless, this miniaturizing of the semiconductor elements leads to such disadvantages as a lowering of the pressure resistance thereof and the possibility that the element will be adversely influenced by hot electrons.

As a countermeasure against these inconveniences, the measure of lowering the power source voltage to be supplied to the semiconductor element, to minimize the electric field strength of the respective portions of the element, is effective. For example, the destruction by aging of an oxidated film can be prevented by lowering the electric field strength of the oxidated film. Further, by lowering the channel electric field strength, the generation of hot electrons can be suppressed, to thereby reduce the amount of hot electrons injected into the oxidated film, i.e., the hot electron instability (concretely, the variation of threshold value $V_{th}$ and a poor conductance) can be prevented.

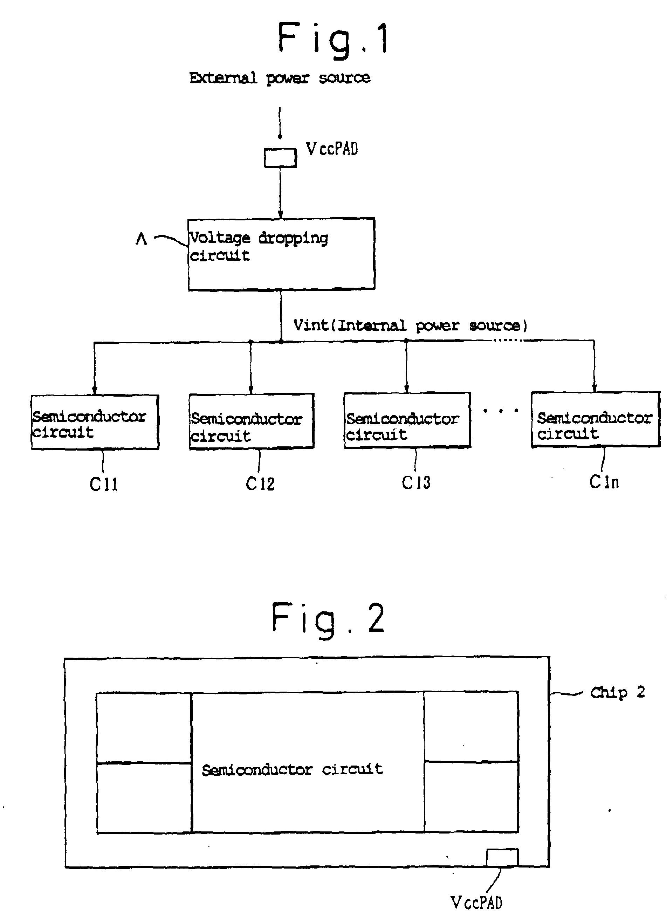

Many of the problems arising in miniaturized elements can be solved if the power source voltage is thus lowered, but it is not preferable for preparation of an exclusive-use external power source because the system will become complex and dedicated power source wires will be required. Therefore, the method of dropping the external power source voltage inside a semiconductor integrated circuit, to thus form a low voltage internal power source, is generally adopted. Fig. 1 and Fig. 2 show the structure of a conventional semiconductor integrated circuit for dropping the external power source voltage inside the semiconductor integrated circuit to produce a low voltage internal power source. In Fig. 1, VccPAD is a power source terminal installed at a semiconductor chip, to which the external power source is to be applied, "A" is a voltage drop circuit, and C11 through C1n represent a plurality ("n" units) of semiconductor circuits. The power source terminal VccPAD is installed, usually as one body, on the semiconductor chip 2, and the semiconductor circuits C11 through C1n are two-dimensionally arranged in the plane of the semiconductor chip 2. The voltage drop circuit "A" forms an internal power source voltage Vint, which drops the external power source voltage applied to the power source terminal VccPAD, to a given voltage. This external voltage is a common power source voltage which is also applied to the other semiconductor integrated circuits and is, for example, +5 V. The voltage is dropped to a given level by utilizing, for example, the channel resistance of a MOS transistor.

The given voltage referred to herein means the voltage necessary for the actuation of a miniaturized semiconductor element (for example, a MOS transistor) forming a structure of a plurality of internal semiconductor circuits C11 through C1n, and moreover, which effectively avoids a pressure resistance and hot electrons.

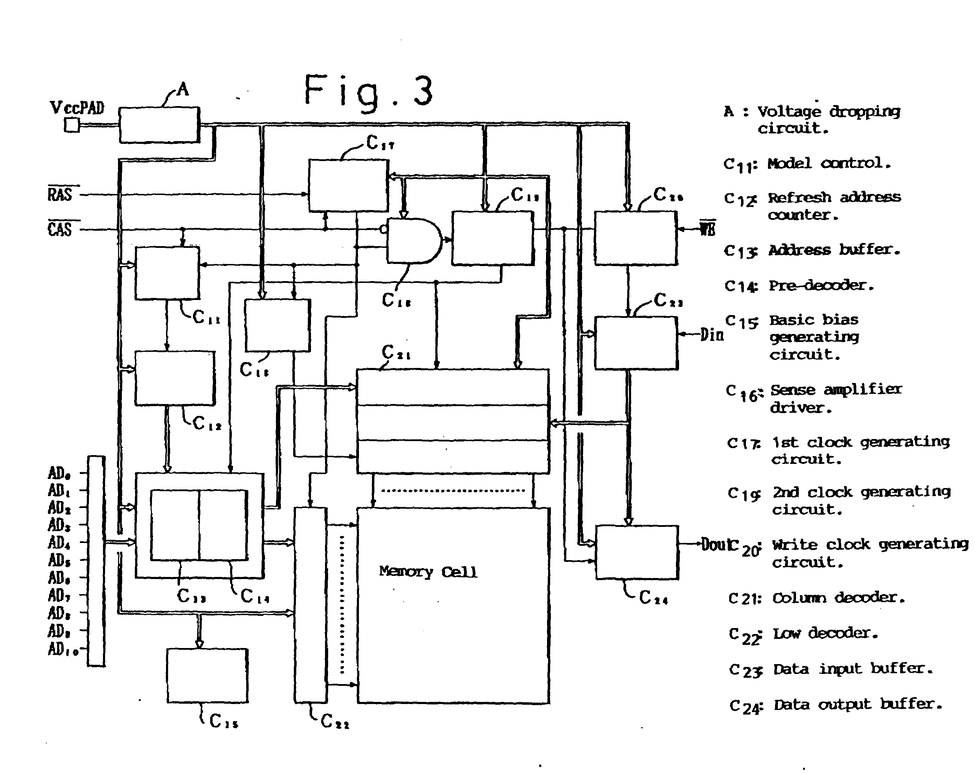

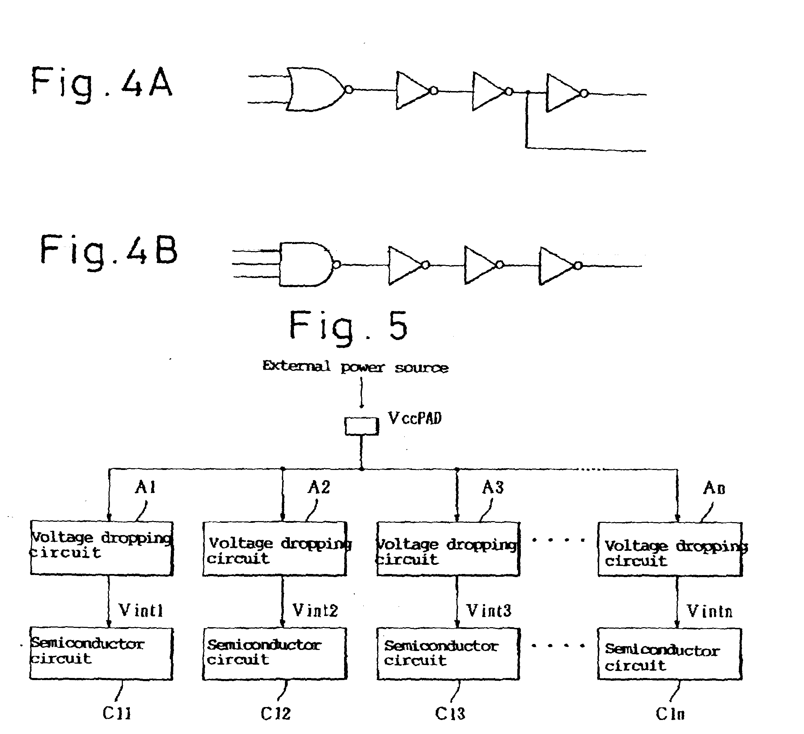

Fig. 3 shows an example of semiconductor circuits C11 through C1n given in Fig. 1, where the semiconductor integrated circuit is a dynamic RAM. In this figure, $C_{11}$ is a mode control circuit, $C_{12}$ a refresh address counter, $C_{13}$ an address buffer, $C_{14}$ a pre-decoder, $C_{15}$ a basic bias generating circuit, $C_{16}$ a sense amplifier driver, $C_{17}$ a first clock generating circuit, $C_{18}$ a gate circuit, $C_{19}$ a second clock generating circuit, $C_{20}$ a write clock generating circuit, $C_{21}$ a column decoder, $C_{22}$ a low decoder, $C_{23}$ a date input buffer and $C_{24}$ a data output buffer, and the internal power source voltage, which has been dropped by the voltage drop circuit "A", can be supplied to each of these semiconductor circuits C11 through C24. Fig. 4A is a circuit diagram showing the structure example of the address buffer of Fig. 3, whereas Fig. 4B is a circuit diagram showing the structure example of the pre-decoder of Fig. 3.

In this type of conventional semiconductor integrated circuit, however, because a plurality of internal semiconductor integrated circuits (C11 through C1n in Fig. 1, and $C_{11}$ through $C_{1n}$ in Fig. 3) use a single internal power source voltage Vint in common, there is a danger that the potential of Vint will drop instantaneously, and thus the other semiconductor circuits may malfunction because of this; for example, when a semiconductor circuit consuming a very large current is actuated outside of these internal semiconductor circuits (C11 through Cln in Fig. 1 and $C_{11}$ through $C_{1n}$ in Fig. 3).

Therefore, a technique is employed such as installing a circuit to detect the voltage drop of the internal power source voltage Vint, and supplying a comparatively large current when the voltage drop has been detected, thus suppress the fluctuations of internal power source voltage. In this method, however, a delay in the response, to a certain degree, was unavoidable until the current was supplied after the actual voltage drop, and as a result, the conventional circuit could not properly effectively suppress the instantaneous voltage drop of internal power source voltage Vint. In on-chip voltage converter is disclosed in IEEE Journal of solid-state circuits SC-22 (1987) June, no.3, pages 437-441.

### DISCLOSURE OF THE INVENTION

Therefore, an object of this invention is to provide a semiconductor integrated circuit capable of effectively suppressing voltage fluctuations in an internal power source voltage, and which will prevent a malfunction of the semiconductor circuits even if a semiconductor circuit consuming a large current is actuated.

A semiconductor integrated circuit according to the present invention is defined in claim 1.

As a result, in this invention, an exclusive use internal power source voltage is formed for each of several semiconductor circuits, and the influence of other internal power source voltages can be avoided if a fluctuation of a single internal power source voltage should occur.

BRIEF DESCRIPTION OF THE DRAWINGS

Fig. 1 is a block circuit diagram showing the structure of conventional semiconductor integrated circuit for dropping the external power source voltage, to thus form a low voltage internal power source;

Fig. 2 is a layout drawing of a plurality of semiconductor circuit chips provided on a semiconductor integrated circuit;

Fig. 3 is a block circuit diagram showing a concrete structural example of a plurality of semiconductor circuits;

Fig. 4A is a circuit diagram showing a structural example of the address buffer of Fig. 3;

Fig. 4B is a circuit diagram showing a structural example of the pre-decoder of Fig. 3;

Fig. 5 is a block circuit diagram showing the structure of a semiconductor integrated circuit in accordance with the present invention, for dropping the external power source voltage to thus generate a low voltage internal power source;

Fig. 6 is a block circuit diagram showing a concrete structural example of a plurality of semiconductor circuits shown in Fig. 5;

Fig. 7 is a circuit diagram showing the circuit structure of a first embodiment of the voltage dropping circuit of Fig. 5;

Fig. 8 is a circuit diagram showing the circuit structure of a further embodiment of the voltage dropping circuit of Fig.5;

Fig. 9 is a block circuit diagram showing a transformed embodiment of a block circuit diagram of Fig. 6;

Fig. 10 is a time-voltage characteristic graph explaining the stability of an internal power source voltage of a semiconductor integrated circuit according to this invention;

Fig. 11 is a circuit diagram of another embodiment of the voltage dropping circuit; and,

Fig. 12 to Fig. 18 are circuit diagrams showing concrete circuit structural examples of the voltage drop controlling circuit of Fig.8.

[Best Mode of Carrying Out the Invention]

The present inventions is now explained with reference to the drawings.

Fig. 5 is a block circuit diagram showing the structure of semiconductor integrated circuit related to the present invention. In Fig. 5, VccPAD indicates a power source terminal for an external power source, A1 through An are voltage dropping circuits, and C11 through C1n are semiconductor circuit blocks, respectively. The voltage dropping circuits A1 through An are installed for each of a plurality of semiconductor internal circuits (semiconductor circuit blocks) C11 through C1n, for dropping the external power source voltage Vcc applied to the power source terminal VccPAD to a given voltage by utilizing, for example, the channel resistance of a MOS transistor, to thus form internal power source voltages from Vint1 through Vntn, respectively.

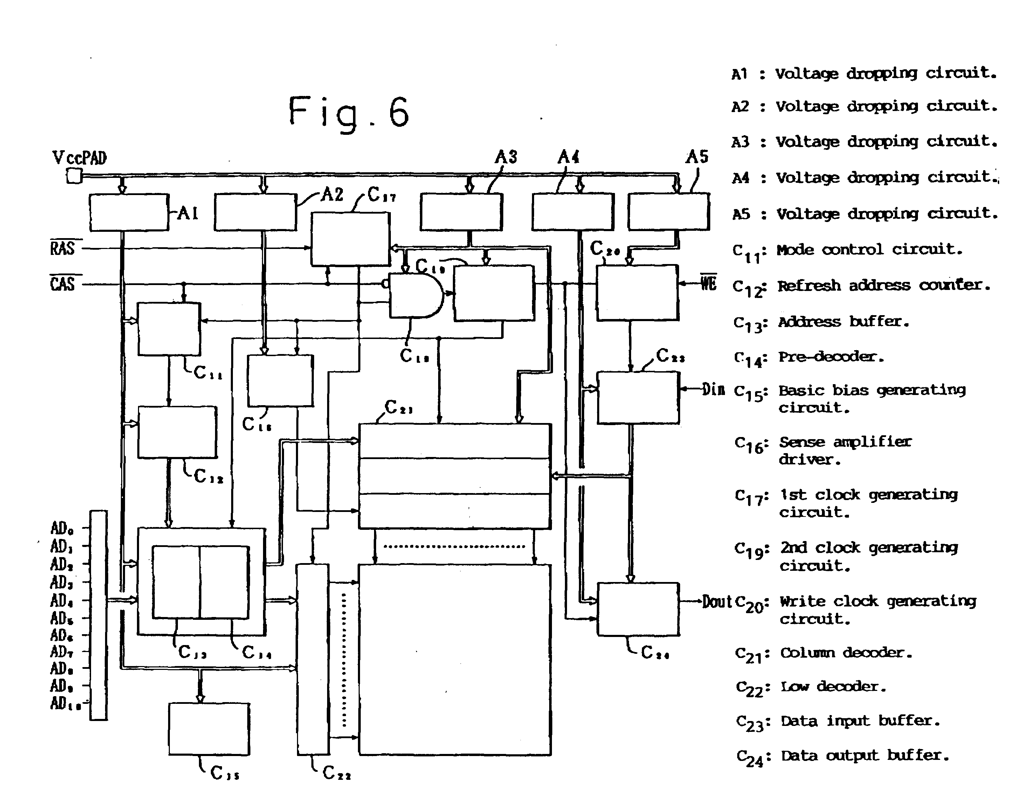

Here, a plurality of semiconductor circuit blocks C11 through C1n are respective functional blocks formed on the semiconductor integrated circuit. For example, in the case of a dynamic RAM (DRAM), such functional blocks as a clock generator and memory cell array (including the sense amplifier) are semiconductor circuit blocks. Fig. 6 shows concrete circuit examples of semiconductor circuits C11 through C1n when the semiconductor integrated circuits are DRAMs, and the same symbols are given as given to identical members of the conventional semiconductor integrated circuit shown in Fig. 3. In Fig. 6, $C_{11}$ is a mode control circuit, $C_{12}$ a refresh address counter, $C_{13}$ an adress buffer, $C_{14}$ a pre-decoder, $C_{15}$ a basic bias generating circuit, $C_{16}$ a sense amplifier driver, $C_{17}$ a 1st clock generating circuit, $C_{18}$ a gate circuit, $C_{19}$ a 2nd clock generating circuit, $C_{20}$ a write clock generating circuit, $C_{21}$ a column decoder, $C_{22}$ a low decoder, $C_{23}$ a data input buffer and $C_{24}$ a data output buffer, respectively, and the internal power source voltage which has been dropped by the voltage dropping circuits A1 through A5 is to be supplied to each of these semiconductor circuits $C_{11}$ through $C_{24}$. The address buffer $C_{13}$ and the pre-decoder $C_{14}$ have the same structures as those shown in Fig. 4A and Fig. 4B.

In this embodiment, the mode control circuit $C_{11}$, refresh address counter $C_{12}$, address buffer $C_{13}$, pre-decoder $c_{14}$, basic bias generating circuit $C_{15}$ and low decoder $C_{22}$ corresponds to the semiconductor circuit C11 of Fig. 5, and are activated by the internal power source voltage Vint1 from the voltage dropping circuit A1. Further, the sense amplifier driver $C_{16}$ corresponds to the semiconductor circuit C12 of Fig. 5 and is activated by the internal power source voltage Vint2 from the voltage dropping circuit A2. Furthermore, the 1st clock generating circuit $C_{17}$, gate circuit $C_{18}$, 2nd clock generating circuit $C_{19}$ and column decoder $C_{21}$ correspond to the semiconductor circuit C13 of Fig. 5 and are activated by the internal power source voltage Vint3 from the voltage dropping circuit A3. In the same way, the data input buffer $C_{23}$ and the data output buffer $C_{24}$ correspond to the semiconductor circuit C14 and are activated by the internal power source voltage Vint4 from the voltage dropping circuit A4, and the write clock generating circuit $C_{20}$ corresponds to the semiconductor circuit C15 and is activated by the internal power source voltage Vint5 from the voltage dropping circuit A5.

Generally, in a DRAM, the operating current of a memory cell array inclusive of the sense amplifier is very high, and therefore, during the actuation of the memory cell array, the current flowing through the voltage dropping circuit A is increased and an instantaneous voltage drop of the internal power source voltage Vint1 occurs. Because, however, in this embodiment this internal power source voltage Vint1 is independent of the internal power source voltages Vint2 through Vint5 of the other semiconductor circuits $C_{12}$ through $C_{15}$, the voltage drops of other internal power source voltages Vint2 through Vint5 can be suppressed even if the power drop occurs in a single internal power source voltage Vint1.

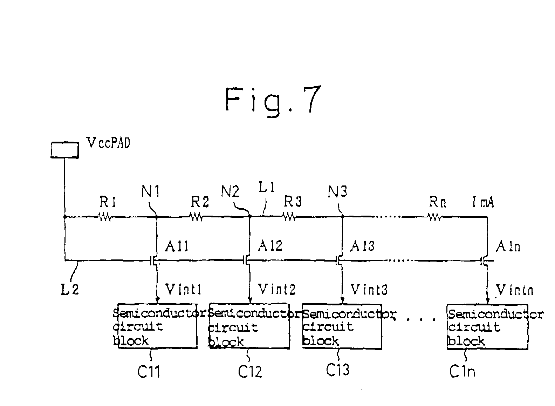

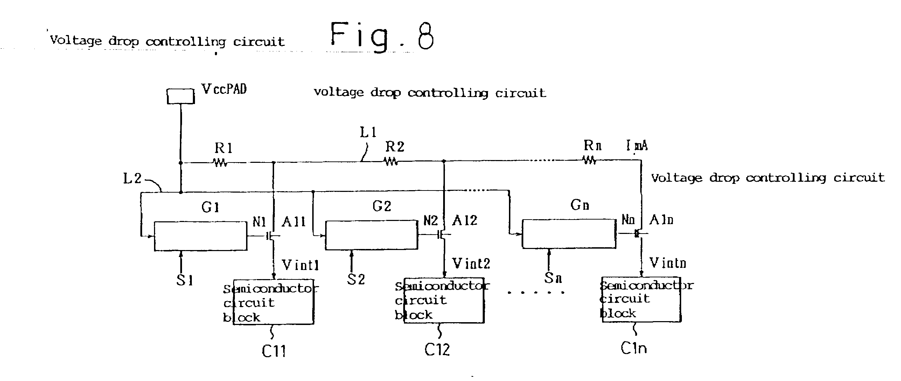

Figs. 7 and 8 are diagrams showing the structures of other semiconductor integrated circuits related to the present invention.

Fig. 7 illustrates an example of the structure of, using MOS transistors, the voltage dropping means A11 through A1n installed at each of a plurality of semiconductor circuit blocks C11 through C1n. In this example, the drain of each MOS transistor is connected to the external power source terminal VccPAD via a 1st common line L1, and the gate of each MOS transistor is connected to the external power source terminal VccPAD via a 2nd common line L2. Note, the resistances R1 through Rn is the 1st common line L1 represent the wiring resistance between the power source terminal VccPAD and the respective MOS transistors.

The following effect can be obtained in accordance with the structure as shown in Fig.7. Namely, assuming a supply of tne power source, from a single external power source terminal VccPAD, to several semiconductor circuits on the chip, because this layout is a two-dimensional plane arrangement as shown in Fig. 2, the wiring lengths between a single power source terminal VccPAD and the respective semiconductor circuits differ from each other, and thus give different wiring resistances. This situation is typically shown by the resistances R1 through Rn in Fig.7.

If a current of ImA flows to the final end C1n of the 1st common line L1, the potentials $VN_1$, $VN_2$, ... $VN_n$ of respective nodes N1 ... Nn in the 1st common line L1 can be expressed by each of the following formulae.

$$VN_1 = Vcc - V_{R1},$$

$$VN_2 = Vcc - (VR_1 + VR_2),$$

$$:$$

$$:$$

$$VNn = Vcc - (V_{R1} + V_{R2} + ... V_{Rn}).$$

Where, Vcc: External power source,

$V_{R1}$: Voltage drop portion by R1 (I, R1),

$V_{R2}$: Voltage drop portion by R2 (I, R2),

$$:$$

$$:$$

$V_{Rn}$: Voltage drop portion by Rn (I, Rn).

These voltage drop portions $V_{R1}$, $V_{R2}$, ... $V_{Rn}$ are given as the multiplied values of the current I mA and the resistance R1 (or R2 ... Rn), and therefore, if a large current (I mA) flows into a single semiconductor circuit (C1n), the other semi-conductor circuits C11, C12 ... are subjected to the influence of the voltage drop portions $V_{R1}$, $V_{R2}$ ... etc.

In this embodiment, however, because the gates of a plurality of MOS transistors to be connected to each of nodes N1 ... Nn are connected to the external power source terminal VccPAD by the 2nd common line L2, which is a dedicated wiring other than the 1st common line L1, (i) the gate potential of each MOS transistor can be made approximately the potential of external power source potential Vcc, since the gate current of MOS transistor is very small (i.e., almost zero), and therefore, (ii) the internal power source voltage Vint1 ... Vintn supplied to the semiconductor circuits C11 ... C1n can be made the constant potentials which have been lowered by the threshold value $V_{th}$ portion of MOS transistor from the external power source potential Vcc, even if a voltage drop occurs at the nodes N1 ... Nn, and (iii) the influence of a voltage drop by the wiring resistances R1 ... Rn in the 1st common line L1 can be effectively avoided.

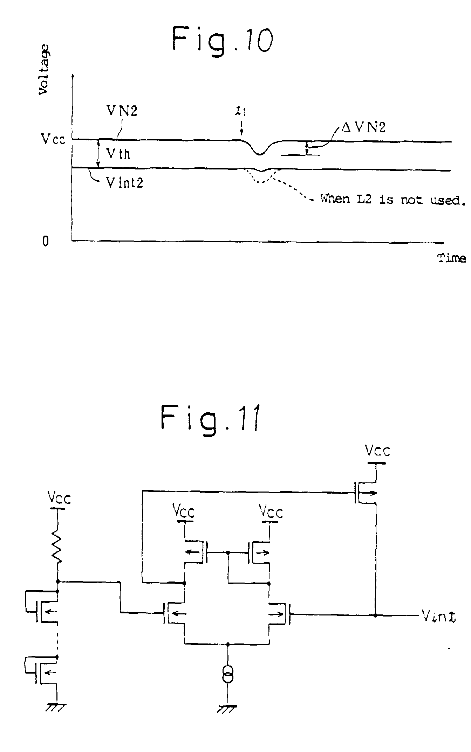

Namely, the internal power source voltage Vint2, for example, of the semiconductor circuit C12 given at the voltage lower by the threshold value $V_{th}$ portion of MOS transistor from the external power source potential Vcc as shown in Fig. 10 is not subjected to the influence of the aforementioned potential difference $\Delta$ VN2, or even if subjected such an influence is slight, and can maintain an almost constant potential (Vcc - $V_{th}$) because the gate potential of MOS transistor is maintained approximately at the external power source potential Vcc by the 2nd common line L2, which is an exclusive-use wiring, even if the potential VN2 of node N2 is lowered by the potential difference $\Delta$VN2 at the time t1. Note, the dotted line in Fig. 10 is the voltage waveform of an example similar to that of Fig.7, except in which the gates are connected to the first common line, and the internal power source voltage Vint2 is greatly fluctuated by the voltage fluctuation of node.

Fig.8 shows a transformed pattern of the embodiment given in Fig.7; identical symbols are given to the same structural portions as those of Fig. 7. In this embodiment the gate of each MOS transistor in the structure of the voltage dropping circuits A11 through A1n is connected to the 2nd common line L2 via the voltage drop controlling circuits G1, G2 ... Gn. In this embodiment, if any of the voltage drop controlling circuits G1 ... Gn, for example, G2 is activated by the individual selection signals S1 ... Sn, the 2nd common line L2 is connected to the gate of MOS transistor A12 via the voltage drop controlling circuit G2 under activation, and thus the gate potential of the MOS transistor can be maintained at approximately the power source voltage Vcc, and thus an effect similar to that of the embodiment shown in Fig.7 is obtained. Furthermore, because in this embodiment the power source supply to the respective semiconductor circuit blocks C11 through C1n can be switched ON and OFF by the individual selection signals S1 through Sn, it is preferably applied to the semiconductor integrated circuit in which an attempt is made to obtain a lower power consumption by dividing, for example, the memory cell array into a plurality of blocks and switching off the power source supply in non-operating blocks.

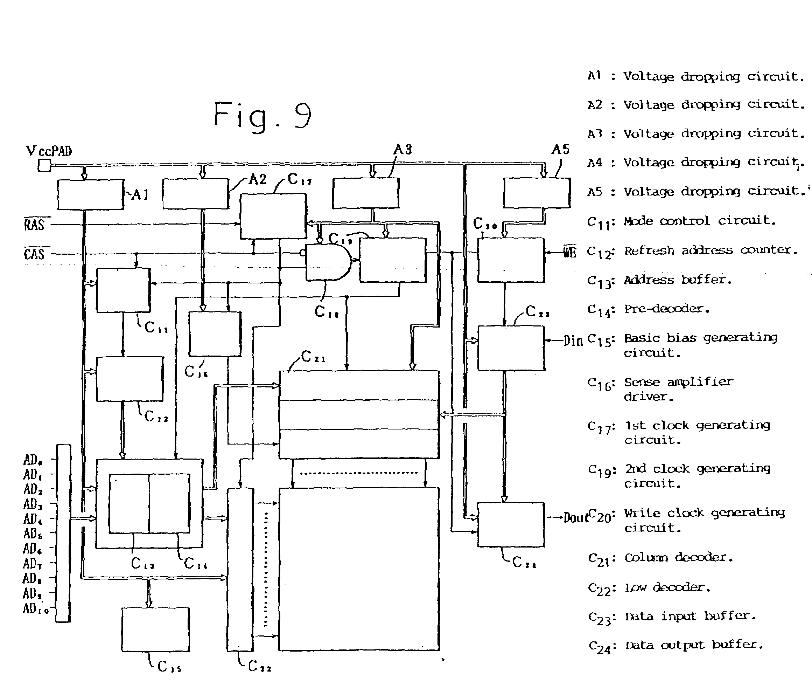

Fig .9 shows the transformed embodiment of a concrete example of the semiconductor circuit blocks C11 through C1n in accordance with the present invention, where the semiconductor integrated circuit shown in Fig. 6 is a DRAM, and is an example of the case wherein the voltage of the external power source does not fall, because the characteristics of the device are to be applied, as is, to the data input buffer $C_{23}$ and the data output buffer $C_{24}$. Because the voltage dropping circuits are installed respectively at each of semiconductor circuits in the semiconductor integrated circuit of this invention, a transformed embodiment considering the characteristics of device is thus available. Further, although the internal power source voltage of the sense amplifier driver $C_{16}$ is formed by the voltage dropping circuit A2 in the circuit in Fig. 9, this voltage dropping circuit A2 need not to be installed at the sense amplifier driver which per se has an external power source voltage dropping action.

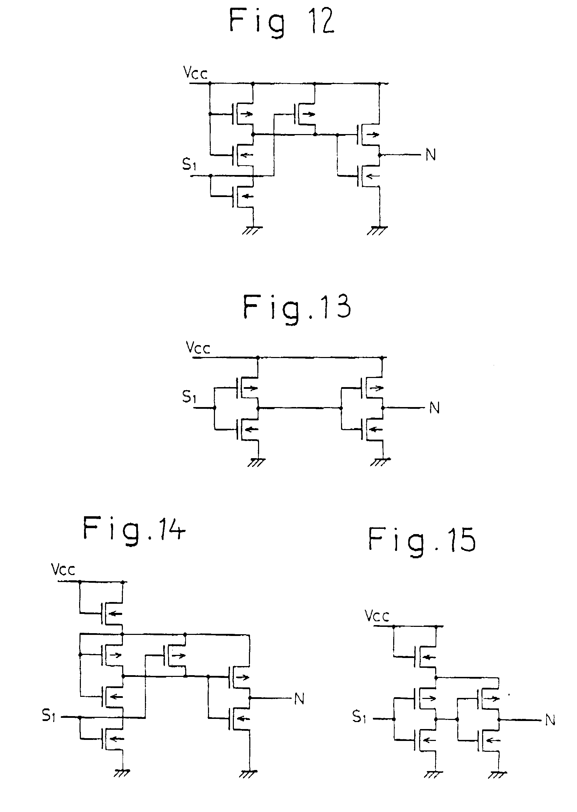

Fig. 11 shows a circuit diagram of an example of a voltage dropping circuit using a plurality of MOS transistors.

Figs 12 and 13 are circuit diagrams showing the concrete circuit structural examples of the voltage drop controlling circuits of Fig.8, and are examples of cases where the voltage drop potential is the external power source voltage Vcc and the threshold value voltage is $V_{th}$. Therefore, because the threshold value voltage is about 1 V when the external power source voltage Vcc is 5 V, the internal power source voltage in the semiconductor integrated circuit using the circuit in this embodiment is about 4 V.

Figs 14 to 17 are circuit diagrams showing other concrete circuit structural examples of the voltage drop controlling circuits of Fig.8, and are examples of cases in which the voltage drop potential is the external power source voltage Vcc and the threshold value voltage is 2 $V_{th}$. Therefore, because the threshold value voltage is about 1 V when the external power source voltage Vcc is 5 V, the internal power source voltage in the semiconductor integrated circuit using the circuit of this embodiment is about 3 V,

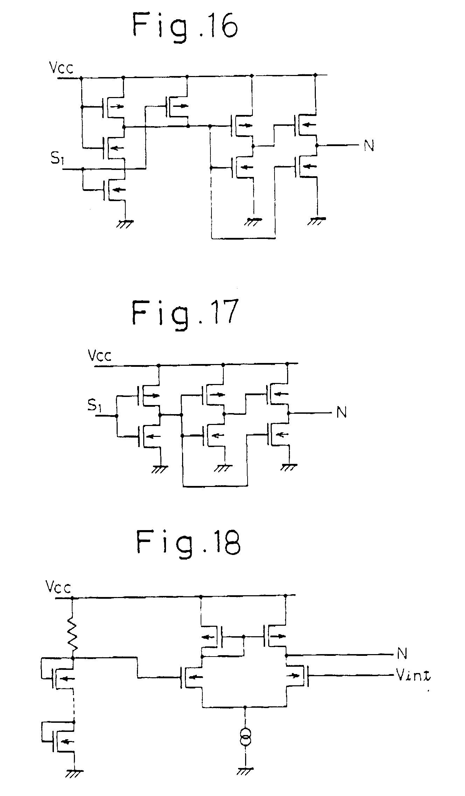

Fig.18 is a circuit diagram showing another concrete circuit structural example of the voltage drop controlling circuit of Fig. 8, and shows a circuit structure whereby the voltage drop potential can be optionally set up.

## Claims

1. A semiconductor integrated circuit for receiving an external power source voltage from outside a semiconductor chip, the semiconductor chip including an external power source terminal (VccPAD) for supplying the external power source voltage to the chip, a plurality of voltage dropping circuits (A11-A1n) within the chip, each of the voltage dropping circuits arranged to drop the external power source voltage to a desired internal power source voltage, and a plurality of semiconductor circuit blocks (C11 - C1n) installed inside the semiconductor chip, and each connected to a respective one of the voltage dropping circuits, characterised in that each of the voltage dropping circuits includes a MOS transistor, and in that the drains of the respective MOS transistors are connected in common through a first common line (L1) connected to said external power source terminal (VccPAD) and gates of respective MOS transistors are also connected to a second common line (L2), said second common line connected to said first common line.

2. A semiconductor integrated circuit according to claim 1, further including voltage drop controlling circuits (G1 - Gn) arranged to independently switch on/off a power source supply to the respective semiconductor circuit blocks (C11 - C1n) by using individual selection signals (S1 - Sn) between the gates of the respective MOS transistors and the second common line.

3. A semiconductor integrated circuit according to claim 2, wherein the external power source voltage is dropped by the threshold level of MOS transistors by the respective voltage drop controlling circuits (G1 - Gn) and the voltage dropping circuits.

4. A semiconductor integrated circuit according to claim 2, wherein the external power source voltage is dropped by twice the threshold level of the MOS transistors by the voltage drop controlling circuits (G1 - Gn) and the voltage dropping circuits.

5. A semiconductor integrated circuit according to claim 2, wherein the voltage drop values of an external power source for each semiconductor circuit blocks (C11 - C1n) are not identical to each other, due to the presence of said respective voltage drop controlling circuits (G1 - Gn) and the voltage dropping circuits.

**Patentansprüche**

1. Integrierte Halbleiterschaltung zum Empfangen einer externen Stromquellenspannung von außerhalb eines Halbleiterchips, wobei das Halbleiterchip einen externen Stromquellenanschluß (VccPAD) zum Zuführen der externen Stromquellenspannung zu dem Chip, eine Vielzahl von Spannungsabsenkschaltungen (A11-A1n) innerhalb des Chips, wobei jede der Spannungsabsenkschaltungen dafür ausgebildet ist, die externe Stromquellenspannung auf eine gewünschte interne Stromquellenspannung abzusenken, und eine Vielzahl von Halbleiterschaltungsblöcken (C11-C1n) aufweist, die innerhalb von dem Halbleiterchip installiert sind und von denen jeder mit einer entsprechenden einen der Spannungsabsenkschaltungen verbunden ist, dadurch **gekennzeichnet,** daß jede der Spannungsabsenkschaltungen einen MOS-Transistor enthält und daß die Drainanschlüsse der jeweiligen MOS-Transistoren über eine erste gemeinsame Leitung (L1) zusammengeschaltet sind, welche Leitung mit dem genannten externen Stromquellenanschluß (VccPAD) verbunden ist, und daß die Gateanschlüsse der jeweiligen MOS-Transistoren auch mit einer zweiten gemeinsamen Leitung (L2) verbunden sind, wobei die zweite gemeinsame Leitung mit der ersten gemeinsamen Leitung verbunden ist.

2. Integrierte Halbleiterschaltung nach Anspruch 1, ferner mit Spannungsabsenk-Steuerschaltungen (G1-Gn), die dafür ausgebildet sind, um unabhängig eine Stromversorgungsquelle zu den jeweiligen Halbleiterschaltungsblöcken (C11-C1n) unter Verwendung von einzelnen Wählsignalen (S1-Sn) zwischen den Gateanschlüssen der jeweiligen MOS-Transistoren und der zweiten gemeinsamen Leitung ein-/auszuschalten.

3. Integrierte Halbleiterschaltung nach Anspruch 2, bei der die externe Stromquellenspannung um den Schwellenwert der MOS-Transistoren durch die jeweiligen Spannungsabsenk-Steuerschaltungen (G1-Gn) und die Spannungsabsenkschaltungen abgesenkt wird.

4. Integrierte Halbleiterschaltung nach Anspruch 2, bei der die externe Stromquellenspannung um das zweifache des Schwellenwertes der MOS-Transistoren durch die Spannungsabsenk-Steuerschaltungen (G1-Gn) und die Spannungsabsenkschaltungen abgesenkt wird.

5. Integrierte Halbleiterschaltung nach Anspruch 2, bei der die Spannungsabsenkwerte der externen Stromquelle für jeden der Halbleiterschaltungsblökke (C11-C1n) nicht untereinander identisch sind, und zwar aufgrund des Vorhandenseins der jeweiligen Spannungsabfall-Steuerschaltungen (G1-Gn) und der Spannungsabsenkschaltungen.

**Revendications**

1. Circuit intégré à semiconducteur pour recevoir une tension de source d'alimentation externe depuis l'extérieur d'une puce semiconductrice, la puce semiconductrice incluant une borne de source d'alimentation externe (VccPAD) pour appliquer la tension de source d'alimentation externe sur la puce, une pluralité de circuits de chute de tension (A11-A1n) dans la puce, chacun des circuits de chute de tension étant agencé pour faire chuter la tension de source d'alimentation externe jusqu'à une tension de source d'alimentation interne souhaitée, et une pluralité de blocs de circuit à semiconducteur (C11-C1n) installés à l'intérieur de la puce semiconductrice dont chacun est connecté à l'un respectif des circuits de chute de tension, caractérisé en ce que chacun des circuits de chute de tension inclut un transistor MOS et en ce que les drains des transistors MOS respectifs sont connectés en commun par l'intermédiaire d'une première ligne commune (L1) connectée à ladite borne de source d'alimentation externe (VccPAD) et des grilles des transistors MOS respectifs sont également connectées à une seconde ligne commune (L2), ladite seconde ligne commune étant connectée à ladite première ligne commune.

2. Circuit intégré à semiconducteur selon la revendication 1, incluant en outre des circuits de commande de chute de tension (G1 - Gn) agencés pour activer/désactiver de manière indépendante une source d'alimentation par rapport aux blocs de circuit à semiconducteur respectifs (C11 - C1n) en utilisant des signaux de sélection individuels (S1 - Sn) entre les grilles des transistors MOS respectifs et la seconde ligne commune.

3. Circuit intégré à semiconducteur selon la revendication 2, dans lequel la tension de source d'alimentation externe est amenée à chuter du niveau de seuil des transistors MOS au moyen des circuits de commande de chute de tension respectifs (G1 - Gn) et des circuits de chute de tension respectifs.

4. Circuit intégré à semiconducteur selon la revendication 2, dans lequel la tension de source d'alimentation externe est amenée à chuter de deux fois le niveau de seuil des transistors MOS au moyen des circuits de commande de chute de tension (G1 - Gn) et des circuits de chute de tension.

5. Circuit intégré à semiconducteur selon la revendication 2, dans lequel les valeurs de chute de tension d'une source d'alimentation externe pour chacun des blocs de circuit à semiconducteur (C11 - C1n) ne sont pas identiques les unes aux autres du fait de la présence desdits circuits de commande de chute de tension respectifs (G1 - Gn) et des circuits de chute de tension respectifs.

# Fig.1

External power source

↓

VccPAD

↓

Λ ── Voltage dropping circuit

↓

Vint(Internal power source)

| Semiconductor circuit | Semiconductor circuit | Semiconductor circuit | · · · | Semiconductor circuit |

C11  C12  C13  C1n

# Fig.2

Chip 2

Semiconductor circuit

VccPAD

# Fig.3

A : Voltage dropping circuit.

$C_{11}$: Model control.

$C_{12}$: Refresh address counter.

$C_{13}$: Address buffer.

$C_{14}$: Pre-decoder.

$C_{15}$: Basic bias generating circuit.

$C_{16}$: Sense amplifier driver.

$C_{17}$: 1st clock generating circuit.

$C_{19}$: 2nd clock generating circuit.

$C_{20}$: Write clock generating circuit.

$C_{21}$: Column decoder.

$C_{22}$: Low decoder.

$C_{23}$: Data input buffer.

$C_{24}$: Data output buffer.

EP 0 454 859 B1

# Fig.4A

# Fig.4B

# Fig.5

External power source

VccPAD

| A1 | A2 | A3 | An |
|---|---|---|---|
| Voltage dropping circuit | Voltage dropping circuit | Voltage dropping circuit | · · · · Voltage dropping circuit |
| Vint1 | Vint2 | Vint3 | Vintn |
| Semiconductor circuit | Semiconductor circuit | Semiconductor circuit | · · · · Semiconductor circuit |
| C11 | C12 | C13 | C1n |

EP 0 454 859 B1

# Fig. 6

VccPAD

A1 A2 C17 A3 A4 A5

RAS

CAS

C20 WE

C11 C18 C19 C23 Din

C12 C16

C21

AD0
AD1
AD2
AD3
AD4
AD5
AD6
AD7
AD8
AD9
AD10

C13 C14 Dout C20

C15 C22

A1 : Voltage dropping circuit.

A2 : Voltage dropping circuit.

A3 : Voltage dropping circuit.

A4 : Voltage dropping circuit.

A5 : Voltage dropping circuit.

$C_{11}$: Mode control circuit.

$C_{12}$: Refresh address counter.

$C_{13}$: Address buffer.

$C_{14}$: Pre-decoder.

$C_{15}$: Basic bias generating circuit.

$C_{16}$: Sense amplifier driver.

$C_{17}$: 1st clock generating circuit.

$C_{19}$: 2nd clock generating circuit.

$C_{20}$: Write clock generating circuit.

$C_{21}$: Column decoder.

$C_{22}$: Low decoder.

$C_{23}$: Data input buffer.

$C_{24}$: Data output buffer.

EP 0 454 859 B1

# Fig.7

Voltage drop controlling circuit

# Fig.8

VccPAD          voltage drop controlling circuit

Voltage drop controlling circuit

L2

R1          L1     R2                    Rn     ImA

G1     N1 | A11      G2     N2 | A12      Gn     Nn | A1n

Vint1                Vint2              Vintn

S1                  S2                 Sn

Semiconductor       Semiconductor      Semiconductor
circuit             circuit            circuit
block               block              block

C11                 C12                C1n

EP 0 454 859 B1

# Fig. 9

A1 : Voltage dropping circuit.

A2 : Voltage dropping circuit.

A3 : Voltage dropping circuit.

A4 : Voltage dropping circuit.

A5 : Voltage dropping circuit.

$C_{11}$: Mode control circuit.

$C_{12}$: Refresh address counter.

$C_{13}$: Address buffer.

$C_{14}$: Pre-decoder.

$C_{15}$: Basic bias generating circuit.

$C_{16}$: Sense amplifier driver.

$C_{17}$: 1st clock generating circuit.

$C_{19}$: 2nd clock generating circuit.

$C_{20}$: Write clock generating circuit.

$C_{21}$: Column decoder.

$C_{22}$: Low decoder.

$C_{23}$: Data input buffer.

$C_{24}$: Data output buffer.

# Fig.10

# Fig.11

# Fig 12

# Fig.13

# Fig.14

# Fig.15

# Fig.16

Vcc

S₁

N

# Fig.17

Vcc

S₁

N

# Fig.18

Vcc

N

Vint